(19) Europäisches Patentamt
European Patent Office
Office européen des brevets

(11) **EP 2 730 801 A1**

(12) **EUROPÄISCHE PATENTANMELDUNG**

(43) Veröffentlichungstag:
**14.05.2014 Patentblatt 2014/20**

(51) Int Cl.:
*F16F 15/00* (2006.01)  *G03F 7/20* (2006.01)

(21) Anmeldenummer: **12191592.0**

(22) Anmeldetag: **07.11.2012**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(71) Anmelder: **Integrated Dynamics Engineering GmbH**
**65479 Raunheim (DE)**

(72) Erfinder: **Kappel, Roland**
**65195 Wiesbaden (DE)**

(74) Vertreter: **Blumbach Zinngrebe**
**Patentanwälte**
**Alexandrastrasse 5**
**65187 Wiesbaden (DE)**

(54) **Als pneumatische Feder ausgebildeter Schwingungsisolator sowie Verfahren zur Abstimmung eines Schwingungsisolators**

(57)    Die Erfindung betrifft einen als pneumatische Feder ausgebildeten Schwingungsisolator (1), bei welchem das Volumen des Arbeitsraumes und/oder die wirksame Kolbenfläche verändert werden kann.

Fig. 3

EP 2 730 801 A1

Printed by Jouve, 75001 PARIS (FR)

**Beschreibung**

Gebiet der Erfindung

Die Erfindung betrifft einen Schwingungsisolator, welcher als pneumatische Feder ausgebildet ist und welcher insbesondere für Schwingungsisolationssysteme verwendet wird, wie sie in der Lithographie verwendet werden. Weiter betrifft die Erfindung ein Verfahren zur Abstimmung eines pneumatischen Schwingungsisolators.

Hintergrund der Erfindung

Schwingungsisolationssysteme, wie sie insbesondere in der Lithographie bei der Herstellung von Halbleiterbauelementen verwendet werden, sind bekannt.

Ein derartiges Schwingungsisolationssystem umfasst üblicherweise einen schwingungsisolierten Aufbau, welcher insbesondere als Tisch ausgebildet ist, der auf zumindest drei Schwingungsisolatoren ruht.

Insbesondere sind pneumatische Federn bekannt, welche als Schwingungsisolator verwendet werden.

Ein derartiger Schwingungsisolator ist beispielsweise in dem Dokument EP 2 071 211 A2 (Integrated Dynamics Engineering GmbH) gezeigt.

Ein derartiger, als pneumatische Feder ausgebildeter Schwingungsisolator kann insbesondere einen Faltenbalg umfassen. Das der Schwingungsisolation dienende Luftvolumen ist so geschlossen, dass dieser insbesondere auch im Vakuum verwendet werden kann.

Aus der Praxis bekannte mit derartigen Schwingungsisolatoren versehene Schwingungsisolationssysteme umfassen im Wesentlichen identisch ausgebildete Schwingungsisolatoren, das heißt die Isolatoren sind insbesondere zum Tragen gleichgroßer Lasten ausgelegt.

In vielen Fällen ist allerdings der Schwerpunkt der isoliert gelagerten Last vom geometrischen Mittelpunkt zwischen den Isolatoren beabstandet, was dazu führt, dass sich die Kraft nicht gleichmäßig auf die Schwingungsisolatoren verteilt.

Gattungsbildende Schwingungsisolationssysteme in der Lithographie sind aber meist als aktive Schwingungsisolationssysteme mit einer Regelschleife ausgebildet und umfassen Sensoren, mit denen zumindest Schwingungen der schwingungsisoliert gelagerten Last gemessen werden und mittels deren direkt oder indirekt die Position des Tisches am Ort des jeweiligen Isolators bestimmt wird.

Über eine Regelschleife kann nunmehr bei einem als pneumatische Feder ausgebildeten Schwingungsisolator der Druck im Arbeitsraum des Isolators angepasst werden, um unterschiedliche Gewichtskräfte auf den Isolatoren zu kompensieren.

Diese Vorgehensweise hat allerdings den Nachteil, dass vielfach die Isolatoren nicht mehr im optimalen Druckbereich betrieben werden.

Weiter besteht bei besonders schweren schwingungsisoliert gelagerten Geräten die Gefahr, dass Schwerpunktsverschiebungen über die Regelschleife nicht mehr abgefangen werden können, etwa weil das System nicht für den dann erforderlichen Eingangsdruck ausgelegt ist.

Dies hat zur Folge, dass bauliche Veränderungen am Schwingungsisolationssystem erforderlich sind, etwa dass durch ein Umbau der schwingungsisoliert gelagerten Last die Schwerpunktsverschiebung reduziert wird.

Aufgabe der Erfindung

Der Erfindung liegt demgegenüber die Aufgabe zugrunde, die genannten Nachteile des Standes der Technik zu reduzieren.

Es ist insbesondere eine Aufgabe der Erfindung, eine einfache Möglichkeit bereit zu stellen, um Verschiebungen des Schwerpunktes einer zu isolierenden Last zu kompensieren.

Zusammenfassung der Erfindung

Die Aufgabe der Erfindung wird bereits durch einen Schwingungsisolator, welcher als pneumatische Feder ausgebildet ist, sowie durch ein Verfahren zur Abstimmung eines Schwingungsisolationssystems nach einem der unabhängigen Ansprüche gelöst.

Bevorzugte Ausführungsformen und Weiterbildungen sind den jeweiligen Unteransprüchen zu entnehmen.

Die Erfindung betrifft einen als pneumatische Feder ausgebildeten Schwingungsisolator.

Insbesondere betrifft die Erfindung vom Grundaufbau her einen Schwingungsisolator, wie dieser in dem Dokument EP 2 071 211 A2 beschrieben ist.

Ein derartiger Schwingungsisolator umfasst einen im Wesentlichen Fluid-dichten Arbeitsraum und arbeitet als pneumatische Feder.

Um ein Oberteil und ein Unterteil des Schwingungsisolators, zumindest in vertikaler Richtung beweglich zu gestalten, ist der Arbeitsraum zumindest abschnittsweise als Faltenbalg, insbesondere als Metallfaltenbalg, ausgebildet.

Der Schwingungsisolator kann des Weiteren noch Sensoren, insbesondere zur Erfassung von Schwingungen und Positionsänderungen der schwingungsisolierten Last, erfassen.

Vorzugsweise ist der Schwingungsisolator, sowohl in vertikaler, als auch in horizontaler Richtung wirksam.

Für die Abstimmung eines derartigen Schwingungsisolators besonders relevant ist die Steifigkeit in horizontaler sowie in vertikaler Richtung, welche zumindest unter anderem auch von der Resonanzfrequenz des Isolators abhängt.

Gemäß der Erfindung wird ein Schwingungsisolator bereitgestellt, bei dem die Kolbenfläche des Arbeitsraumes und/oder das Volumen der pneumatischen Feder veränderbar sind.

Vorzugsweise sind Kolbenfläche und Volumen des Arbeitsraumes veränderbar.

Unter der Kolbenfläche im Sinne der Erfindung wird diejenige Fläche verstanden, welche bei anliegendem Druck zur Erzeugung einer Kraft wirksam ist.

Bei einer pneumatischen Feder, welche einen Faltenbalg aufweist, entspricht in der Regel der Durchmesser des Faltenbalgs der wirksamen Kolbenfläche, da sich in angrenzenden Volumina Kräfte, die durch den Druck erzeugt werden, ansonsten gegenseitig aufheben.

Zur einfachen Veränderung der Kolbenfläche ist insbesondere vorgesehen, dass der Schwingungsisolator ein austauschbares Modul mit einem Faltenbalg aufweist.

Es ist insbesondere vorgesehen, den Faltenbalg mit Flanschen zu versehen, welche an dem restlichen Gehäuse des Schwingungsisolators befestigt, insbesondere angeschraubt, werden können.

Auf diese Weise kann die Kolbenfläche verändert werden, ohne ansonsten den Schwingungsisolator baulich verändern zu müssen.

Zu Veränderung des Volumens der pneumatischen Feder ist bei einer Ausführungsform der Erfindung ein austauschbares Gehäuseteil vorgesehen, welches ein Zusatzvolumen bereitstellt, mittels dessen Dimensionierung des Volumens des Arbeitsraumes auf sehr einfache Weise vergrößert oder verringert werden kann.

Da die Eigenfrequenz eines als pneumatische Feder ausgebildeten Schwingungsisolators im Wesentlichen bestimmt ist durch die Wurzel aus dem Quotienten der Kolbenfläche und dem Volumen, ändert sich bei einer Veränderung der Kolbenfläche, etwa durch Austausch des Faltenbalges, auch die Eigenfrequenz.

Diese in vielen Fällen nicht erwünschte Änderung kann nunmehr durch einen Austausch des Fluid-Zusatzvolumens kompensiert werden.

Das Zusatzvolumen ist vorzugsweise leicht zugänglich unterhalb einer Bodenplatte des Schwingungsisolators angeordnet.

Durch die bevorzugte Kombination einer veränderbaren Kolbenfläche und eines veränderbaren Volumens des Arbeitsraumes wird eine sehr einfache Anpassbarkeit des Isolators an eine veränderte Last ermöglicht.

Bei einer Weiterbildung der Erfindung umfasst der Schwingungsisolator ein in vertikaler Richtung vom Faltenbalg beabstandetes Drehgelenk.

Metallfaltenbalg und Drehlager bilden so ein Knickpendel.

Grundsätzlich wird die horizontale Steifigkeit des Isolators durch die mechanischen Komponenten, insbesondere durch den Metallfaltenbalg, bestimmt.

In Kombination mit einem beabstandeten Drehgelenk wird durch das Drehgelenk eine negative horizontale Steifigkeit bereitgestellt, wodurch eine niedrige horizontale Steifigkeit erreichbar ist.

Wird nunmehr durch die negative Steifigkeit des Drehgelenks eine insgesamt negative Steifigkeit erzielt, die also in einem instabilen System mündet, kann, wie es bei einer weiteren Ausführungsform der Erfindung vorgesehen ist, zur Aufbringung einer zusätzlichen horizontalen Steifigkeit eine Feder hinzugefügt werden. Eine derartige Feder kann insbesondere als Blattfeder ausgestaltet sein.

Vorzugsweise ist in der pneumatischen Feder ein Positionssensor angeordnet, mit welchem insbesondere Schwingungen der isoliert gelagerten Last erfasst werden. Unter einem Positionssensor wird mithin nicht nur ein Sensor verstanden, der die absolute Position der schwingungsisoliert gelagerten Last detektiert, sondern jeglicher Sensor, welcher eine mit der Position in Beziehung stehende Größe, beispielsweise Beschleunigung oder Geschwindigkeit, erfasst.

Die Sensoren können insbesondere als induktive Sensoren, kapazitive Sensoren oder Piezosensoren ausgebildet sein.

Der Schwingungsisolator ist vorzugsweise derart aufgebaut, dass die pneumatische Feder ein Unterteil aufweist, welches über einen Faltenbalg mit dem Oberteil verbunden ist und wobei das Oberteil, vorzugsweise über ein Drehgelenk, mit der zu isolierenden Last verbunden ist.

Die Erfindung betrifft des Weiteren ein Schwingungsisolationssystem, welches mehrere der vorstehend beschriebenen Schwingungsisolatoren umfasst.

Dabei haben insbesondere zumindest zwei der Schwingungsisolatoren ein unterschiedliches Fluidvolumen und/oder eine unterschiedliche Kolbenfläche, sind aber ansonsten im Wesentlichen identisch aufgebaut und besitzen insbesondere gleichartig ausgebildete Gehäusekomponenten und weisen die gleichen Außenmaße auf.

Der Schwerpunkt einer schwingungsisolierten Last kann dabei von dem geometrischen Mittelpunkt der Schwingungsisolatoren beabstandet sein.

Unterschiede in der daraus resultierenden Kraftverteilung auf den Isolatoren werden zumindest teilweise durch eine unterschiedliche Kolbenfläche kompensiert.

Die Erfindung betrifft des Weiteren ein Verfahren zur Abstimmung eines Schwingungsisolationssystems, insbesondere eines Schwingungsisolationssystems, wie es vorstehend beschrieben ist.

Dabei wird zunächst die Lage des Schwerpunktes einer zu isolierenden Last bestimmt.

Anhand der Größe der zu isolierenden Last sowie anhand der geometrischen Position des Schwerpunktes kann nunmehr eine optimierte Kolbenfläche, zumindest eines als pneumatische Feder ausgebildeten Schwingungsisolators, bestimmt und insbesondere berechnet werden.

Unter einer optimierten Kolbenfläche wird verstanden, dass die in dem Schwingungsisolationssystem vorhandenen Kolbenflächen sich derart unterscheiden, dass an einer Stelle mit höherer Gewichtskraft eine größere Kolbenfläche verwendet wird.

Es versteht sich, dass es nicht nötig ist, die Kolbenfläche exakt anhand der am jeweiligen Ort vorhandenen Kraft abzustimmen. Es reicht vielmehr, dass die Kolbenfläche derart geändert wird, dass innerhalb einer gewissen Regelbandbreite des Schwingungsisolationssystems der Druck an einem Isolator innerhalb der Bandbreite des Drucks liegt, mit dem dieser sinnvoll betrieben werden kann. Anhand der berechneten optimalen Kolbenfläche wird die Kolbenfläche des Schwingungsisolators geändert.

Bei einer Weiterbildung der Erfindung wird nunmehr auch das Volumen des als pneumatische Feder ausgebildeten Schwingungsisolators geändert, um eine Eigenfrequenzänderung aufgrund der Änderung der Kolbenfläche zumindest teilweise zu kompensieren.

Beschreibung der Zeichnungen

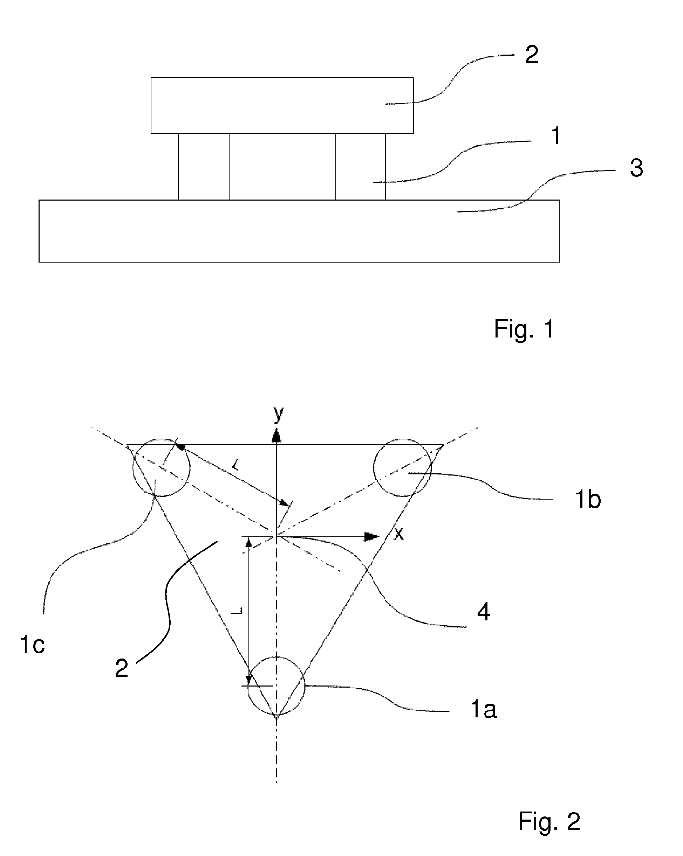

Die Erfindung soll im Folgenden Bezug nehmend auf ein schematisch dargestelltes Ausführungsbeispiel anhand der Zeichnungen Fig. 1 bis Fig. 5 näher erläutert werden.

Fig. 1 zeigt schematisch das Grundprinzip eines Schwingungsisolationssystems.

Das Schwingungsisolationssystem umfasst eine zu isolierende Last 2, welche über Schwingungsisolatoren 1 auf dem Boden 3 gelagert ist. Es versteht sich, dass es sich in der Praxis um ein komplexes System mit einer Vielzahl von Bauteilen handelt, die nicht dargestellt sind.

Die Schwingungsisolatoren 1 sind als pneumatische Federn ausgebildet und verfügen über eine Regelschleife derart, dass über Sensoren (nicht dargestellt) Schwingungen oder Positionsänderungen erfasst werden und der Druck in der pneumatischen Feder über eine Regelschleife geregelt wird. Fig. 2 zeigt eine weitere schematische Ansicht eines Schwingungsisolationssystems, welches als Dreibein ausgebildet ist.

Dieses umfasst die zu isolierende Last 2, die insbesondere einen Tisch umfassen kann, auf dem eine zu isolierende Maschine gelagert ist.

Die zu isolierende Last 2 ist auf den als pneumatische Feder ausgebildeten Schwingungsisolatoren 1a bis 1c gelagert.

Die Berechnung einer optimierten Kolbenfläche kann bei einem in Fig. 2 dargestellten Schwingungsisolationssystem wie folgt erfolgen.

Die Schwingungsisolatoren 1a bis 1c bilden die Basis für die schwingungsisolierte Last 2, wobei sich die Wirklinien der Isolatoren im geometrischen Mittelpunkt 4 treffen.

Die drei Isolatoren 1 a bis 1c befinden sich jeweils in einem Abstand L vom geometrischen Mittelpunkt, die Richtungen x und y liegen entlang der Haupterstreckungsrichtung der zu isolierenden Last 2.

Wenn sich der Massenschwerpunkt der isolierten Last 2 aus dem geometrischen Mittelpunkt 4 heraus auf Koordinaten (Sx, Sy) verschiebt, dann lassen sich die benötigten Kräfte an den Einzelisolatoren (Iso1 (1a), Iso2 (1b), Iso3 (1c)) berechnen, wenn die Gesamtmasse M und die Länge L gegeben ist.

Die an den Isolatoren wirksamen Kräfte seien mit F1, F2 und F3 bezeichnet. Dann gilt für das Dreibein wie skizziert:

$$F_1 := [\, 0, 0, F1 \,]$$

$$F_2 := [\, 0, 0, F2 \,]$$

$$F_3 := [\, 0, 0, F3 \,]$$

$$Iso_1 := [\, 0, -L, 0 \,]$$

$$Iso_2 := \left[\, \frac{1}{2}\sqrt{3}\,L, \frac{1}{2}L, 0 \,\right]$$

$$Iso_3 := \left[\, -\frac{1}{2}\sqrt{3}\,L, \frac{1}{2}L, 0 \,\right]$$

$$S := [\, Sx, Sy, 0 \,]$$

Und es müssen die Gleichungen gelten

$$I \qquad \sum_{i=1}^{3} \vec{F}_i \times (\vec{Iso}_i - \vec{S}) = \vec{0}$$

$$II \quad \wedge \quad \sum_{i=1}^{3} \vec{F}_i = \begin{pmatrix} 0 \\ 0 \\ Mg \end{pmatrix}$$

Wobei (II) nichts anderes sagt, als dass die Summe der Kräfte aller Isolatoren in vertikaler Richtung gleich der Gewichtskraft der zu isolierenden Masse sein soll (g ist die Erdbeschleunigung). Gleichung (I) verlangt zudem, dass die Drehmomente der Kräfte an den Isolatoren, die am Schwerpunkt S angreifen in der Summe gleich Null sein müssen.
Daraus ergeben sich die Einzelgleichungen

$$-F_1 \cdot (-L - S_y) - F_2 \cdot (\tfrac{L}{2} - S_y) - F_3 \cdot (\tfrac{L}{2} - S_y) = 0$$

$$-F_1 \cdot S_x + F_2 \cdot (\tfrac{1}{2}\sqrt{3}L - S_x) + F_3 \cdot (-\tfrac{1}{2}\sqrt{3}L - S_x) = 0 \; ,$$

$$F_1 + F_2 + F_3 = gM$$

woraus man die Einzelkräfte berechnen kann, die bei einer Schwerpunktsverschiebung auf S aufzubringen sind:

$$F_1 = -\frac{1}{3}\frac{Mg(-L+2S_y)}{L},$$

$$F_2 = \frac{1}{3}\frac{Mg(\sqrt{3}S_x+L+S_y)}{L},$$

$$F_3 = -\frac{1}{3}\frac{Mg(\sqrt{3}S_x-L-S_y)}{L}$$

verglichen zum Lastfall im geometrischen Mittelpunkt $( F_i = \frac{1}{3}Mg )$ ergibt sich also eine Abweichung von

$$\Delta F_1 = 1 - \frac{2S_y}{L},$$

$$\Delta F_2 = 1 + \frac{(\sqrt{3}S_x+S_y)}{L},$$

$$\Delta F_3 = 1 + \frac{(S_y-\sqrt{3}S_x)}{L}$$

Die Kraft eines pneumatischen Isolators wird bestimmt durch dessen Druck im Inneren und der wirksamen Fläche (Kolbenfläche):

$$F_i = pA = p\frac{\pi}{4}d_i^{\,2}$$

Die Kraftänderung verläuft also linear mit dem Druck, aber quadratisch mit dem Durchmesser der Kolbenfläche.
Die Eigenfrequenz des Isolators ist proportional zur Wurzel des Quotienten aus Kolbenfläche und Volumen:

$$\omega_0 = \sqrt{\frac{nAg}{V}}$$

(mit g=Erdbeschleunigung und n=Gaskonstante Luft (1.4)).

Soll diese bei veränderter Kolbenfläche gleich gehalten werden, muss auch das Volumen V angepasst werden:

$$V = \frac{1}{4} \frac{nAg}{\omega^2}$$

Lagern beispielsweise 1200kg auf dem als Dreibein ausgebildeten Schwingungsisolationssystem gemäß Fig. 2, so trägt jeder Isolator im Mittelpunktsfalle 1200/3=400kg. Ist der Massenschwerpunkt bei einer Schenkellänge von L=0.75m verschoben um (0.1,0.1)m, so ergeben sich veränderte Soll-Werte für die Isolatoren von F1=293kg, F2=546kg, F3=361kg

Trug ein Isolator bei einem Kolbendurchmesser von d=0.1m und 5bar Druck gerade 400kg, so müssten nun entweder der Druck in den Isolatoren verändert werden auf p1=3.66bar, p2=6.92bar, p3=4.51bar, was bei einem typischerweise maximal verfügbaren Druck von 6 bar schon eine Grenze überschreitet.

Mittels der Erfindung kann der Druck auf 5 bar belassen und eine Anpassung des Kolbendurchmessers durchgeführt werden:

d1=0.085, d2=0.117, d3=0.095

Entscheidet man sich für die Erhöhung des Kolbendurchmessers bei Iso2, so würde dies eine Eigenfrequenzänderung zur Folge haben, die proportional zum Verhältnis der Durchmesser ist.

Bei einer ursprünglichen Eigenfrequenz von 0.5Hz wäre in diesem Fall (0.1 auf 0.117 = 17%) eine Eigenfrequenz von 0.585 zu erwarten.

Ist dies nicht erwünscht, kann das Volumen entsprechend angepasst werden. Da dies umgekehrt proportional eingeht, ist also eine Erhöhung um 17% notwendig, um wieder auf die ursprüngliche Eigenfrequenz zu kommen.

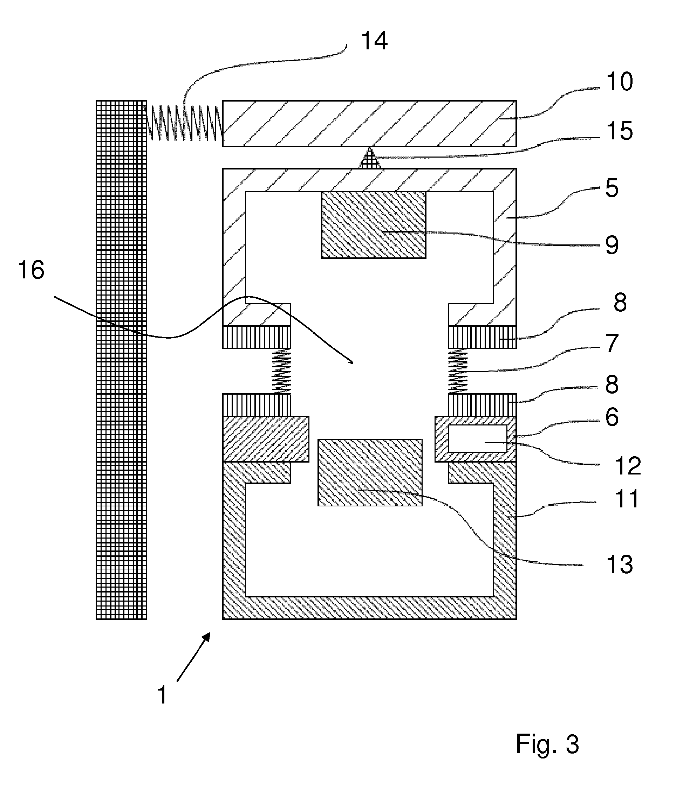

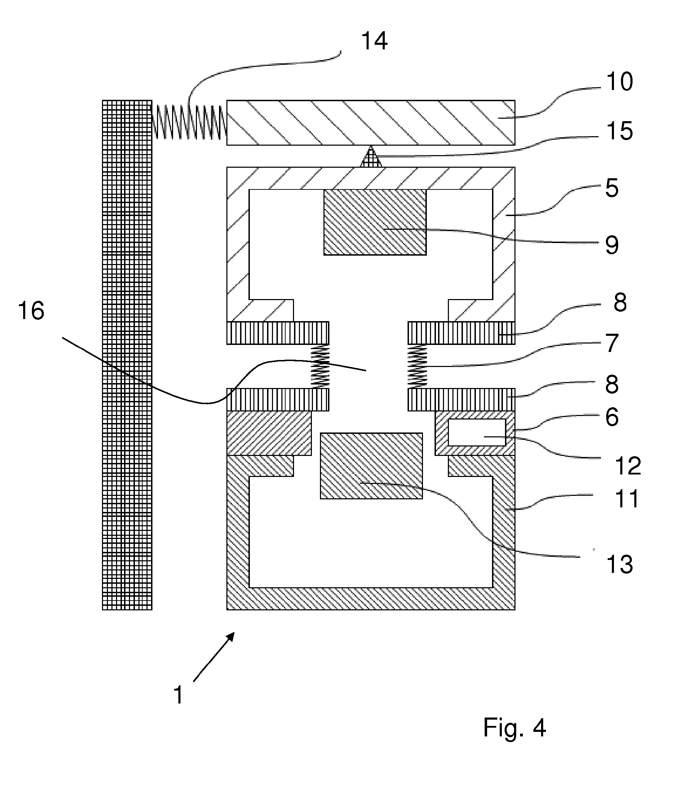

Fig. 3 und Fig. 4 zeigen eine schematische Darstellung eines als pneumatische Feder ausgebildeten Schwingungsisolators in einer Schnittansicht.

Der Schwingungsisolator 1 umfasst ein Oberteil 5 und ein Unterteil 6. Zwischen dem Oberteil 5 und dem Unterteil 6 ist ein Faltenbalg 7 angeordnet.

Das Gehäuse ist ansonsten bis auf die Fluidzuführung (nicht dargestellt) abgeschlossen und der im Arbeitsraum des Schwingungsisolators herrschende Druck stellt eine Schwingungsisolation sowohl in horizontaler als auch in vertikaler Richtung bereit.

Das Unterteil 6 umfasst eine Durchführung 12 für Kabel.

Im Inneren des Arbeitsraumes 16 ist zumindest ein Sensor 9 angeordnet, welcher Schwingungen der isoliert gelagerten Last erfasst.

Bei der hier dargestellten Ausführungsform eines Schwingungsisolators ist zwischen einem Kopfstück 10 und dem Oberteil 5 ein Drehgelenk 15 angeordnet. Faltenbalg 7 und Drehgelenk 15 bilden mithin ein Knickpendel und durch das Drehgelenk 15 wird eine negative Steifigkeit in horizontaler Richtung bereitgestellt, welche die positive Steifigkeit der mechanischen Komponenten, insbesondere des Faltenbalgs 7 kompensiert.

Je nach Ausführungsvariante kann, um das System nicht instabil werden zu lassen, am Kopfstück 10 eine Feder 14 zur Aufbringung einer zusätzlichen positiven Steifigkeit in horizontaler Richtung angreifen.

Die Feder 14 kann insbesondere als Blattfeder (nicht dargestellt) ausgebildet sein, insbesondere als Blattfeder, deren Federkraft verstellbar ist.

Der hier dargestellte Schwingungsisolator umfasst des Weiteren Mittel zur Aufbringung einer negativen Steifigkeit 13 in vertikaler Richtung. Hierdurch soll auch in vertikaler Richtung die positive Steifigkeit aufgrund der mechanischen Komponenten reduziert werden.

Zur Aufbringung einer negativen Steifigkeit kann insbesondere eine magnetische Federeinrichtung verwendet werden. Eine solche ist insbesondere in dem Dokument EP 1 359 341 B1 (Integrated Dynamics Engineering GmbH) beschrieben.

Die wirksame Kolbenfläche wird bei dem hier dargestellten Schwingungsisolator im Wesentlichen durch den Durchmesser des Faltenbalgs 7 bestimmt.

Der Faltenbalg 7 umfasst beidseitig Flansche 8, welche abschraubbar ausgebildet sind und mittels derer der Faltenbalg mit dem Oberteil 5 und dem Unterteil 6 verbunden ist.

Vorzugsweise sind diese Flansche im zusammengebauten Zustand von außen zugänglich, so dass keine weiteren Bauteile demontiert werden müssen.

Da nunmehr der Faltenbalg als austauschbares Modul ausgebildet ist, ist es auf sehr einfache Weise möglich, die wirksame Kolbenfläche zu verändern.

Weiter umfasst der Schwingungsisolator unterhalb vom Unterteil 6 ein austauschbares Zusatzvolumen 11, welches ebenfalls von außen zugänglich ist und durch dessen Austausch sich auch auf sehr einfache Weise das Volumen des Arbeitsraumes des Schwingungsisolators ändern lässt, um die Eigenfrequenz des Schwingungsisolators 1 zu ändern.

Zu erkennen ist, dass der Durchmesser des Faltenbalges 7 in Fig. 4 nach Austausch desselben deutlich kleiner ist, mithin der in Fig. 4 dargstellte Schwingungsisolator 1 nunmehr zur Aufnahme einer kleineren Kraft vorgesehen ist als der Schwingungsisolator, der in Fig. 3 dargestellt ist.

Durch die Erfindung konnte ein Schwingungsisolator bereitgestellt werden, welcher auf sehr einfache Weise eine Anpassung an eine unterschiedliche Last ermöglicht.

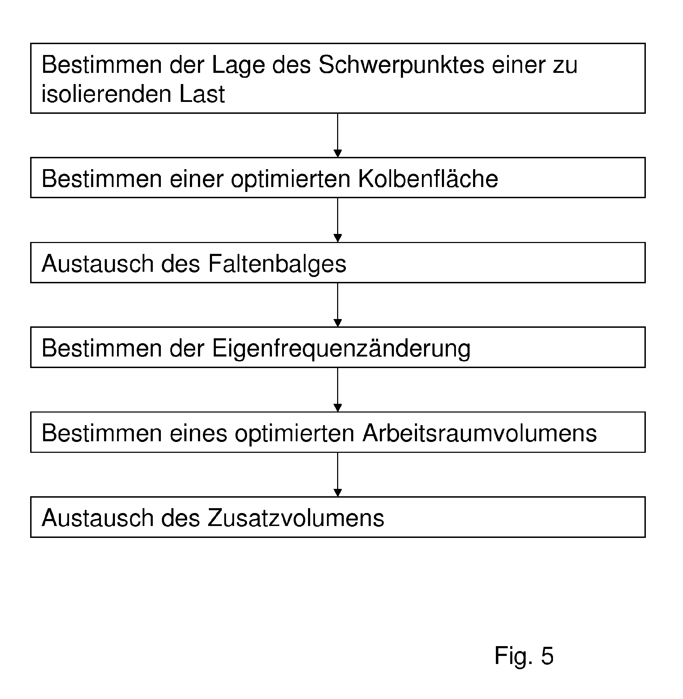

Bezugnehmend auf Fig. 5 sollen die wesentlichen Verfahrensschritte eines Verfahrens zur Abstimmung eines Schwingungsisolationssystems erläutert werden.

Zunächst wird die Lage des Schwerpunktes einer zu isolierenden Last bestimmt.

Sofern die Lage des Schwerpunktes vom geometrischen Mittelpunkt zwischen den Schwingungsisolatoren abweicht, wird sodann eine optimierte Kolbenfläche bestimmt.

Auf dieser Basis wird zumindest ein Faltenbalg eines Isolators des Schwingungsisolationssystems ausgetauscht, um die ungleiche Lastverteilung zumindest teilweise zu kompensieren.

Durch den Austausch des Faltenbalges ändert sich das Volumen des Arbeitsraumes.

Daher wird die damit einhergehende Eigenfrequenzänderung bestimmt und auf dieser Basis das Zusatzvolumen des Arbeitsraumes ausgetauscht, um die Eigenfrequenzänderung zumindest teilweise zu kompensieren.

Bezugszeichenliste

| 1 | Schwingungsisolator |
|---|---|
| 2 | zu isolierende Last |
| 3 | Boden |
| 4 | geometrischer Mittelpunkt |
| 5 | Oberteil |
| 6 | Unterteil |
| 7 | Faltenbalg |
| 8 | Flansch |
| 9 | Sensor |
| 10 | Kopfstück |
| 11 | Zusatzvolumen |
| 12 | Kabeldurchführung |
| 13 | Mittel zur Aufbringung einer negativen Steifigkeit |
| 14 | Feder |
| 15 | Drehgelenk |
| 16 | Arbeitsraum |

**Patentansprüche**

1. Schwingungsisolator (1), ausgebildet als pneumatische Feder, **dadurch gekennzeichnet, dass** die Kolbenfläche und/oder das Volumen der pneumatischen Feder veränderbar ist.

2. Schwingungsisolator (1) nach dem vorstehenden Anspruch, **dadurch gekennzeichnet, dass** der Schwingungsisolator zur Veränderung der Kolbenfläche ein austauschbares Modul mit einem Faltenbalg (7) aufweist.

3. Schwingungsisolator (1) nach dem vorstehenden Anspruch, **dadurch gekennzeichnet, dass** das Modul an einem Gehäuse anbringbare Flansche (8) aufweist.

4. Schwingungsisolator (1) nach einem der vorstehenden Ansprüche, **dadurch gekennzeichnet, dass** der Schwingungsisolator (1) ein austauschbares Gehäuseteil aufweist, welches ein Fluid-Zusatzvolumen (11) bereitstellt.

5. Schwingungsisolator (1) nach einem der vorstehenden Ansprüche, **dadurch gekennzeichnet, dass** der Schwingungsisolator (1) einen Faltenbalg (7) mit einem geschlossenen Fluidvolumen sowie ein horizontal vom Faltenbalg beabstandetes Drehgelenk (15) aufweist.

**6.** Schwingungsisolator (1) nach einem der vorstehenden Ansprüche, **dadurch gekennzeichnet, dass** der Schwingungsisolator (1) eine Feder (14) zur Erzeugung einer zusätzlichen horizontalen Steifigkeit aufweist.

**7.** Schwingungsisolator (1) nach einem der vorstehenden Ansprüche, **dadurch gekennzeichnet, dass** der Schwingungsisolator Mittel zum Hinzufügen einer negativen Steifigkeit (13) aufweist.

**8.** Schwingungsisolator (1) nach einem der vorstehenden Ansprüche, **dadurch gekennzeichnet, dass** in der pneumatischen Feder zumindest ein Positionssensor angeordnet (9) ist.

**9.** Schwingungsisolator (1) nach einem der vorstehenden Ansprüche, **dadurch gekennzeichnet, dass** die pneumatische Feder ein Unterteil (6) aufweist, das über einen Faltenbalg (7) mit einem Oberteil (5) verbunden ist, wobei das Oberteil (5) vorzugsweise über ein Drehgelenk (14) mit der zu isolierenden Last (1) verbunden ist.

**10.** Schwingungsisolationssystem, umfassend mehrere Schwingungsisolatoren (1) nach einem der vorstehenden Ansprüche.

**11.** Schwingungsisolationssystem nach dem vorstehenden Anspruch, **dadurch gekennzeichnet, dass** zumindest zwei der Schwingungsisolatoren (1a-1c) ein unterschiedliches Fluidvolumen und/oder eine unterschiedliche Kolbenfläche aufweisen.

**12.** Schwingungsisolationssystem nach dem vorstehenden Anspruch, **dadurch gekennzeichnet, dass** die Schwingungsisolatoren (1a-1c) im Wesentlichen identische Außenmaße aufweisen.

**13.** Schwingungsisolationssystem nach einem der vorstehenden Ansprüche, **dadurch gekennzeichnet, dass** der Schwerpunkt einer schwingungsisoliert gelagerten Last von dem geometrischen Mittelpunkt (4) der Schwingungsisolatoren beabstandet angeordnet ist.

**14.** Verfahren zur Abstimmung eines Schwingungsisolationssystems, insbesondere eines Schwingungsisolationssystems nach einem der vorstehenden Ansprüche, umfassend die Schritte:

- Bestimmen der Lage des Schwerpunktes einer zu isolierenden Last,
- Bestimmen einer optimierte Kolbenfläche zumindest eines als pneumatische Feder ausgebildeten Schwingungsisolators,
- Ändern der Kolbenfläche.

**15.** Verfahren zur Abstimmung eines Schwingungsisolationssystems nach dem vorstehenden Anspruch, **dadurch gekennzeichnet, dass** das Volumen des als pneumatische Feder ausgebildeten Schwingungsisolators geändert wird, um eine Eigenfrequenzänderung aufgrund der Änderung der Kolbenfläche zu kompensieren.

2

1

3

Fig. 1

y

L

x

1b

4

1c

2

L

1a

Fig. 2

Fig. 3

Fig. 4

| Bestimmen der Lage des Schwerpunktes einer zu isolierenden Last |
|---|

↓

| Bestimmen einer optimierten Kolbenfläche |
|---|

↓

| Austausch des Faltenbalges |
|---|

↓

| Bestimmen der Eigenfrequenzänderung |
|---|

↓

| Bestimmen eines optimierten Arbeitsraumvolumens |
|---|

↓

| Austausch des Zusatzvolumens |
|---|

Fig. 5

**Europäisches Patentamt**
**European Patent Office**
**Office européen des brevets**

# EUROPÄISCHER RECHERCHENBERICHT

**Nummer der Anmeldung**

EP 12 19 1592

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 6 126 152 A (SANTOS JAMES P [US] ET AL) 3. Oktober 2000 (2000-10-03) * Abbildungen 7,8,15,16,17 * ----- | 1-6,8-15 | INV. F16F15/00 G03F7/20 |
| X | EP 2 034 210 A2 (BFS DIVERSIFIED PRODUCTS LLC [US]) 11. März 2009 (2009-03-11) * das ganze Dokument * ----- | 1-5,8-15 | |
| X | US 6 408 767 B1 (BINNARD MIKE [US] ET AL) 25. Juni 2002 (2002-06-25) * Abbildung 2 * ----- | 1,10 | |

**RECHERCHIERTE SACHGEBIETE (IPC)**

F16F

Der vorliegende Recherchenbericht wurde für alle Patentansprüche erstellt

| Recherchenort | Abschlußdatum der Recherche | Prüfer |
|---|---|---|
| Den Haag | 3. Mai 2013 | Kovács, Endre |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
...............................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 12 19 1592

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

03-05-2013

| Im Recherchenbericht angeführtes Patentdokument | | Datum der Veröffentlichung | Mitglied(er) der Patentfamilie | | Datum der Veröffentlichung |
|---|---|---|---|---|---|
| US 6126152 | A | 03-10-2000 | CA | 2231262 A1 | 10-09-1998 |
| | | | US | 6126152 A | 03-10-2000 |
| EP 2034210 | A2 | 11-03-2009 | EP | 2034210 A2 | 11-03-2009 |
| | | | US | 2009065989 A1 | 12-03-2009 |
| | | | US | 2012248667 A1 | 04-10-2012 |
| US 6408767 | B1 | 25-06-2002 | KEINE | | |

Für nähere Einzelheiten zu diesem Anhang : siehe Amtsblatt des Europäischen Patentamts, Nr.12/82

EPO FORM P0461

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2071211 A2
- EP 1359341 B1